# FASCICULE DE BREVET EUROPEEN

(11) **EP 0 935 271 B1**
(45) Date de publication et mention de la délivrance du brevet: **29.11.2006**
(21) Numéro de dépôt: 99400226.9
(22) Date de dépôt: 02.02.1999
(51) Int. Cl.: H01H 71/02, H05K 5/02, H02B 1/44, E05D 7/10

(54) **Capot à volet monté pivotant, notamment pour platine de disjoncteur**
Scharnierdeckel insbesonderes für Schalterabdeckung
Hinged cover especially for circuit breaker front

(30) Priorité: 04.02.1998 FR 9801285
(43) Date de publication de la demande: 11.08.1999
(73) Titulaire: LEGRAND FRANCE, 87000 Limoges (FR); LEGRAND SNC, 87000 Limoges (FR)
(72) Inventeur: Combas, Christian, 87240 Ambazac (FR); Mazabraud, Pierre, 87000 Limoges (FR)
(74) Mandataire: Santarelli

(56) Documents cités:
- EP-A- 0 748 015
- GB-A- 2 134 591
- US-A- 5 327 682
- PATENT ABSTRACTS OF JAPAN vol. 016, no. 119 (M-1225), 25 mars 1992 & JP 03 286081 A (MATSUSHITA ELECTRIC IND CO LTD), 17 décembre 1991

## Description

La présente invention concerne d'une manière générale les capots du genre comportant une paroi de façade, dans laquelle est ménagée une fenêtre, et un volet, qui est monté pivotant entre une position de fermeture, pour laquelle il occulte cette fenêtre, et une position d'ouverture, pour laquelle il libère celle-ci.

Ces capots peuvent être destinés à être rapportés sur un quelconque support, et, par exemple, sur un corps de boîte.

La présente invention vise cependant plus particulièrement le cas où ils sont destinés à être rapportés sur une platine de disjoncteur, c'est-à-dire sur une platine servant de support à un disjoncteur.

L'une des difficultés à surmonter dans la réalisation des capots de ce type tient à l'articulation du volet, notamment lorsque la fenêtre qu'il a à charge d'occulter comporte, le long de certains au moins de ses bords, et, par exemple, le long de chacun de ceux-ci, sur une partie au moins de la longueur de tels bords, un retour dirigé vers l'intérieur.

Il importe, en effet, que, lors de son débattement, le volet ne vienne pas interférer avec un tel retour par son bord correspondant.

Cette difficulté peut se trouver accrue si, suivant par exemple une forme générale cylindrique, la surface avant de la paroi de façade est bombée, et/ou si certains au moins des bords de sa fenêtre sont cintrés.

La présente invention a d'une manière générale pour objet une disposition permettant de surmonter de manière particulièrement simple cette difficulté.

De manière plus précise, elle a pour objet un capot du genre comportant une paroi de façade, dans laquelle est ménagée une fenêtre, et un volet, qui est monté pivotant entre une position de fermeture, pour laquelle il occulte cette fenêtre, et une position d'ouverture pour laquelle il libère celle-ci, ce capot étant d'une manière générale caractérisé en ce que, la fenêtre de la paroi de façade comportant, le long de chacun de deux bords latéraux, dits ci-après par simple commodité bords transversaux, sur une partie au moins de la longueur de ces bords transversaux, un retour, qui est dirigé vers l'intérieur, et dans lequel est ménagé en creux un dégagement, et le volet comportant, en correspondance, en saillie sur chacun de ses deux bords transversaux, un tourillon, qui s'étend parallèlement à sa surface avant, à proximité d'un de ses bords longitudinaux, et par lequel il est en prise à pivotement avec le dégagement du retour correspondant de la fenêtre de la paroi de façade, les deux tourillons que comporte ainsi le volet sont chacun tronqués par un méplat en correspondance l'un avec l'autre.

Grâce à ce méplat, l'axe réel de pivotement du volet se déplace lors du débattement de celui-ci, en sorte que, au lieu de balayer un arc de cercle, le bord longitudinal correspondant de ce volet peut, si désiré, avantageusement suivre une ligne droite.

Ainsi, lorsque, le long de celui de ses bords longitudinaux à proximité duquel se fait le pivotement du volet, la fenêtre de la paroi de façade comporte un retour dirigé vers l'intérieur, la section transversale de ce retour peut être une droite, ce qui facilite avantageusement le moulage du capot suivant l'invention.

En outre, le volet équipant ce capot peut ainsi avantageusement s'encastrer dans la fenêtre de la paroi de façade en position de fermeture, au bénéfice de l'esthétique de l'ensemble.

Le brevet US 5 327 682 décrit, pour l'équipement d'une ouverture pratiquée dans un mur, un cadre comportant un retour dirigé vers l'intérieur et une porte pivotante démontable, avec des tourillons cylindriques de pivotement dans des cavités oblongues où ils bénéficient d'un certain jeu, ce jeu constituant le moyen d'éviter les risques de coincement de la porte.

Confronté à un tel élément de l'état de la technique, la présente invention peut s'analyser comme proposant, pour éviter tout risque de coincement d'un organe d'obturation articulé, volet ou porte du type considéré, une action positive de guidage assurant une variation de la position de l'axe réel de rotation par rapport à une portée d'appui grâce à un profil de came conféré aux tourillons en sorte que cette position devient une fonction prédéterminée de l'angle d'ouverture du moyen d'obturation.

Les caractéristiques et avantages de l'invention ressortiront d'ailleurs de la description qui va suivre, à titre d'exemple, en référence aux dessins schématiques annexés sur lesquels :
la figure 1 est une vue en perspective d'un capot suivant l'invention, pour la position de fermeture de son volet ;
la figure 2 est une vue en perspective analogue à celle de la figure 1, pour la position d'ouverture de ce volet ;
la figure 3 est une vue en perspective éclatée, qui est déduite de celle de la figure 1, et sur laquelle le capot est représenté vu de l'avant tandis que son volet est représenté vu de l'arrière ;
la figure 4 reprend, à échelle supérieure, pour le capot, le détail de la figure 3 repéré par un encart IV sur cette figure 3 ;
la figure 5 est une vue partielle en coupe transversale de ce capot, suivant la ligne V-V de la figure 4 ;
la figure 6 reprend, à échelle supérieure, le détail de la figure 5 repéré par un encart VI sur cette figure 5 ;
les figures 7 et 8 reprennent, chacune respectivement, pour le volet, les détails de la figure 3 repérés par des encarts VII et VIII sur cette figure 3 ;
la figure 9 est, à échelle différente, une vue partielle de côté du volet, suivant la flèche IX de la figure 8 ;
les figures 10A, 10B et 10C sont des vues partielles en coupe transversale, qui, reprises de celle de la figure 5, illustrent, chacune respectivement, de manière volontairement simplifiée, diverses positions de ce volet ;
la figure 11 est une vue partielle en coupe transversale, qui, analogue à celle de la figure 10C, en illustre, de manière schématique, une autre caractéristique.

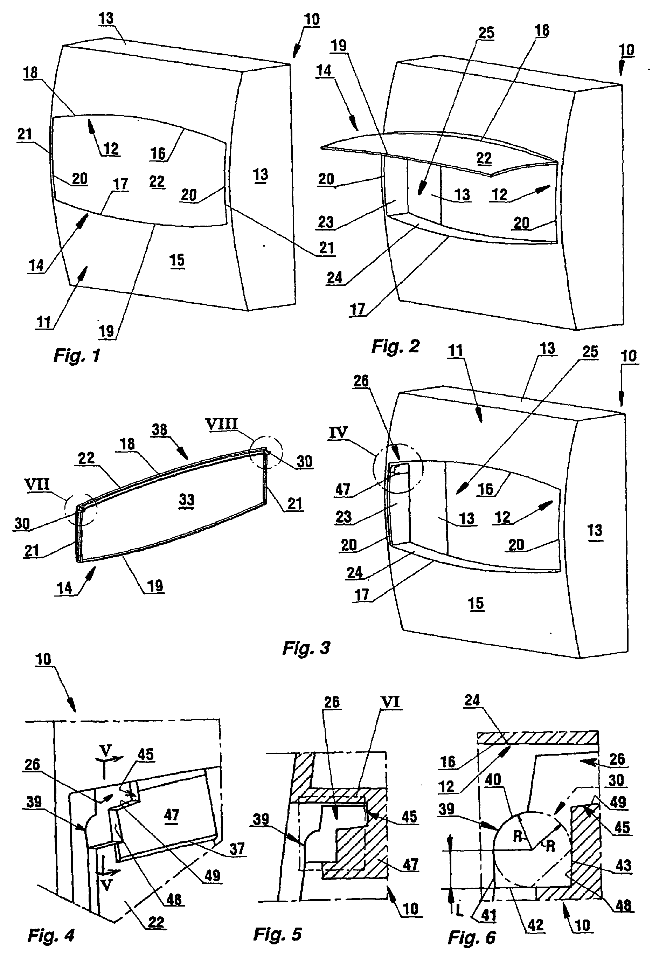

Tel qu'illustré sur ces figures, le capot 10 suivant l'invention comporte une paroi de façade 11, dont le contour est, par exemple, globalement rectangulaire, tel que représenté, et dans laquelle est ménagée une fenêtre 12, quatre parois de côté 13, qui, pour la paroi de façade 11, forment des retours dirigés vers l'arrière, en s'étendant chacun sensiblement perpendiculairement à cette paroi de façade 11, et, dans la fenêtre 12 de la paroi de façade 11, un volet 14, qui est monté pivotant entre une position de fermeture, pour laquelle, tel que représenté sur la figure 1, il occulte cette fenêtre 12, et une position d'ouverture, pour laquelle, tel que représenté sur la figure 2, il libère celle-ci.

Dans la forme de réalisation représentée, la surface avant 15 de la paroi de façade 11 est bombée, suivant une forme générale cylindrique de génératrices horizontales, et, conjointement, le volet 14 est monté pivotant autour d'un axe qui, parallèle aux génératrices de cette surface avant 15, est lui-même horizontal.

En outre, dans cette forme de réalisation, les bords longitudinaux supérieur 16 et inférieur 17 de la fenêtre 12 de la paroi de façade 11 sont cintrés, avec leurs concavités tournées l'une vers l'autre, et, en correspondance, les bords longitudinaux supérieur 18 et inférieur 19 du volet 14 sont eux-mêmes cintrés de manière sensiblement complémentaire, avec leurs propres concavités également tournées l'une vers l'autre.

En revanche, les bords transversaux 20 de la fenêtre 12 de la paroi de façade 11 sont droits, et il en est de même des bords transversaux 21 correspondants du volet 14.

Préférentiellement, et tel que représenté, le volet 14 est bombé, à la manière de la surface avant 15 de la paroi de façade 11.

Préférentiellement, également, il s'encastre dans la fenêtre 12 de la paroi de façade 11 lorsqu'il est en position de fermeture, et sa surface avant 22 vient alors en continuité avec la surface avant 15 de cette paroi de façade 11.

Dans la forme de réalisation représentée, le volet 14 s'étend à l'horizontale lorsqu'il est en position d'ouverture, à la manière d'un auvent.

Suivant l'invention, la fenêtre 12 de la paroi de façade 11 comporte, le long de chacun de ses bords transversaux 20, sur une partie au moins de la longueur de ces bords transversaux 20, un retour 23, qui est dirigé vers l'intérieur, et qui, donc, s'étend vers l'arrière, à la manière des parois de côté 13.

Dans la forme de réalisation représentée, la fenêtre 12 de la paroi de façade 11 comporte, également, le long de celui au moins de ses bords longitudinaux 16, 17 à proximité duquel se fait le pivotement du volet 14, en l'espèce son bord longitudinal 16 supérieur, et ainsi qu'il est mieux visible sur les figures 5 et 6, un retour 24, qui, lui aussi, est dirigé vers l'intérieur.

Suivant l'invention, la section transversale de ce retour 24, au moins, est une droite.

En pratique, et tel que représenté, la fenêtre 12 de la paroi de façade 11 comporte, aussi, un retour 24 le long de son autre bord longitudinal, en l'espèce son bord longitudinal 17 inférieur.

Préférentiellement, et cela est le cas dans la forme de réalisation représentée, les retours 23, 24 de la fenêtre 12 de la paroi de façade 11 s'étendent chacun respectivement sur toute la longueur des bords 20, 16-17 de celle-ci, et ils forment donc, conjointement, tout au long du contour de cette fenêtre 12, un cadre 25.

Préférentiellement, également, la section transversale de chacun de ces retours 23, 24 est une droite, et, abstraction faite d'un éventuel angle de dépouille, celle-ci s'étend sensiblement perpendiculairement à la paroi de façade 11, ce qui facilite le moulage du capot 10.

Suivant l'invention, dans chacun des retours 23 de la fenêtre 12 de la paroi de façade 11 de ce capot 10 est ménagé, en creux, suivant des dispositions décrites plus en détail ultérieurement, un dégagement 26, et le volet 14 comporte, en correspondance, en saillie sur chacun de ses deux bords transversaux 21, un tourillon 30, qui s'étend parallèlement à sa surface avant 22 à proximité d'un de ses bords longitudinaux 18, 19, en l'espèce son bord longitudinal 18 supérieur, et par lequel il est en prise à pivotement avec le dégagement 26 du retour 23 correspondant de la fenêtre 12 de cette paroi de façade 11.

Suivant l'invention, également, les deux tourillons 30 que comporte ainsi le volet 14 s'étendent en retrait par rapport au bord longitudinal 18 correspondant de celui-ci, c'est-à-dire par rapport à son bord longitudinal 18 supérieur, et ils sont déportés vers l'intérieur par rapport à sa surface avant 22.

Alignés l'un avec l'autre, ces deux tourillons 30 matérialisent l'axe de pivotement du volet 14.

En pratique, ils s'étendent dos à dos aux extrémités du bord longitudinal 18 supérieur correspondant de ce volet 14.

Suivant l'invention, ces deux tourillons 30 sont chacun tronqués par un méplat 32, en correspondance l'un avec l'autre.

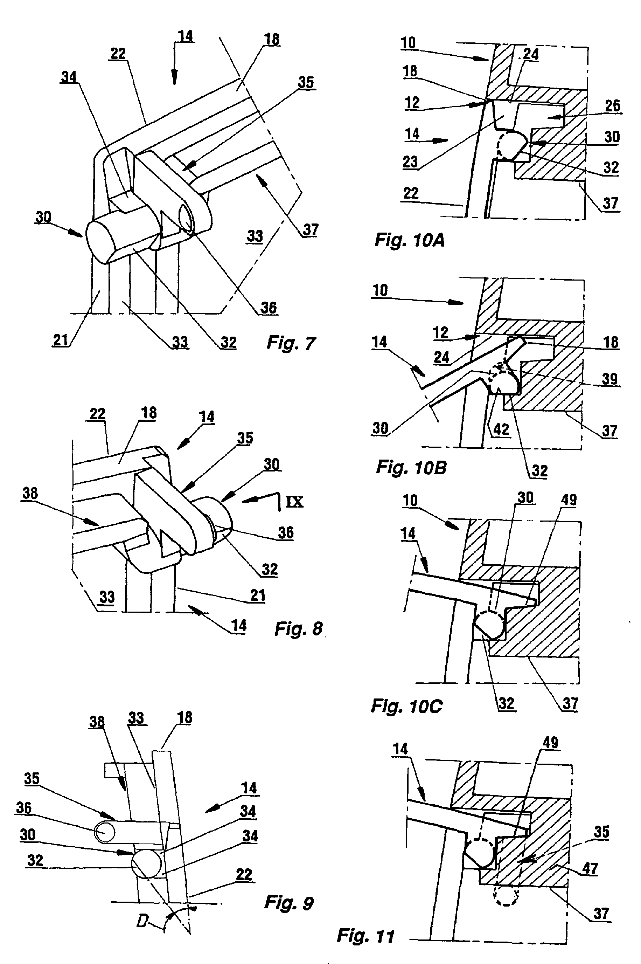

Tel qu'il a été repéré sur la figure 9, ce méplat 32 fait un dièdre D d'angle aigu avec la surface avant 22 du volet 14, et, ainsi qu'il ressort conjointement de la figure 3, il est tourné vers le bord longitudinal 18, 19 opposé de celui-ci, en l'espèce son bord longitudinal 19 inférieur.

Préférentiellement, l'angle de ce dièdre D est compris entre 30° et 60°.

Par exemple, il est de l'ordre de 45°.

Dans la forme de réalisation représentée, chacun des tourillons 30 du volet 14 fait saillie sur la surface arrière 33 de celui-ci, en se raccordant à cette surface arrière 33 par une nervure 34 formant globalement pour lui un berceau.

Dans la forme de réalisation représentée, le volet 14 comporte, également, en saillie sur sa surface arrière 33, le long de chacun de ses bords transversaux 21, un bras de maintien 35, qui s'étend sensiblement perpendiculairement à sa surface avant 22, et qui est élastiquement déformable, avec, en saillie vers l'extérieur sur ce bras de maintien 35, à l'extrémité libre de celui-ci, un bossage 36 propre à son encliquetage sur un épaulement 37 prévu à cet effet en correspondance sur le retour 23 correspondant de la fenêtre 12 de la paroi de façade 11, figures 4, 10A, 10B, 10C et 11.

Enfin, dans la forme de réalisation représentée, le volet 14 comporte, en saillie sur sa surface arrière 33, parallèlement à ses bords longitudinaux 18, 19 et à ses bords transversaux 21, en retrait par rapport à ceux-ci, des nervures qui forment globalement un cadre 38, et à l'extérieur desquelles s'étendent ses tourillons 30 et ses bras de maintien 35.

Dans la forme de réalisation représentée, le dégagement 26 que présente chacun des retours 23 de la fenêtre 12 de la paroi de façade 11 comporte un lobe 39 propre à un débattement du tourillon 30 correspondant du volet 14 eu égard au méplat 32 que présente un tel tourillon 30, le contour de ce lobe 39, dit ici par simple commodité lobe de débattement, comportant, notamment, figure 6, un côté curviligne 40, en arc de cercle, dont la concavité est tournée vers l'intérieur et vers le bord longitudinal 16, 17 opposé de la fenêtre 12, en l'espèce son bord longitudinal 17 inférieur, et qui s'étend sur environ 90°, suivant un rayon R sensiblement égal au rayon R du tourillon 30, un premier côté droit 41, qui, dirigé vers ce bord longitudinal 17 inférieur de la fenêtre 12, est tangent au côté curviligne 40, et dont la longueur L est au moins égale au rayon R du tourillon 30, et un deuxième côté droit 42, qui, dirigé vers l'intérieur, fait un angle sensiblement droit avec le premier côté droit 41.

Par exemple, et tel que représenté, la longueur L du premier côté droit 41 du lobe de débattement 39 du dégagement 26 est sensiblement égale au rayon R des tourillons 30.

Dans la forme de réalisation représentée, le lobe de débattement 39 de ce dégagement 26 comporte un troisième côté droit 43, qui, dirigé vers le bord longitudinal 16, 17 concerné de la fenêtre 12, en l'espèce son bord longitudinal 16 supérieur, s'étend sensiblement parallèlement au premier côté droit 41, et le dégagement 26 comporte, à compter de ce troisième côté droit 43 et du côté curviligne 40, un deuxième lobe 45, qui s'étend globalement vers l'intérieur, et dit ci-après par simple commodité lobe de montage.

Dans la forme de réalisation représentée, le deuxième côté droit 42 du lobe de débattement 39 du dégagement 26 est sensiblement parallèle à la section transversale des retours 24 de la fenêtre 12 de la paroi de façade 11, et, donc, à celle du retour 24 que cette fenêtre 12 présente le long de celui de ses bords longitudinaux 16, 17, en l'espèce son bord longitudinal 16 supérieur, à proximité duquel se fait le pivotement du volet 14.

Enfin, dans la forme de réalisation représentée, l'épaulement 37 prévu sur les retours 23 que cette fenêtre 12 présente conjointement le long de chacun de ses bords transversaux 20 appartient à un bossage 47, qui vient en surépaisseur par rapport à ces retours 23, et qui, s'étendant jusqu'au dégagement 26 que présentent ceux-ci, forme, le long de la partie correspondante de ce dégagement 26, des épaulements 48, 49 de largeur accrue, l'un le long du lobe de débattement 39 de ce dégagement 26, l'autre le long de son lobe de montage 45.

Préférentiellement, le capot 10, d'une part, et le volet 14, d'autre part, sont en matière synthétique, et ils sont réalisés par moulage, chacun individuellement.

Ainsi qu'on le notera, aucun autre constituant n'est nécessaire, les tourillons 30 et les bras de maintien 35 du volet 14 ne formant qu'une seule et même pièce avec celui-ci.

Au montage, le volet 14 est engagé à force dans la fenêtre 12 de la paroi de façade 11 du capot 10, moyennant une déformation élastique temporaire, jusqu'à ce que ses tourillons 30 viennent en prise avec les dégagements 26 des retours 23 de la fenêtre 12 de cette paroi de façade 11.

Lorsque, tel que schématisé sur les figures 10A, 10B et 10C, le volet 14 est pivoté de sa position d'ouverture à sa position de fermeture, ses tourillons 30, initialement au contact du côté curviligne 40 du lobe de débattement 39 de ces dégagements 26, s'écartent de ce côté curviligne 40 à la faveur de la capacité de débattement résultant de leur méplat 32, jusqu'à venir temporairement se plaquer par ce méplat 32 contre le deuxième côté droit 42 de ce lobe de débattement 39, tel que représenté à la figure 10B.

Lors d'une première étape de l'ouverture du volet, figure 10A, une arête du méplat 32 des tourillons, dite arête avant, est en contact avec le deuxième côté 42 du lobe de 39 de débattement formant portée d'appui et glisse sur celle-ci. Conjointement, la deuxième arête du méplat 32 des tourillons, dite arête arrière, entre en contact avec le troisième coté droit 43 du lobe de débattement 39 et glisse sur celui-ci, puis la partie cylindrique des tourillons proche de l'arête arrière glisse sur le troisième coté droit 43 du lobe de débattement 39. Pendant cette première étape de l'ouverture du volet, l'axe des tourillons 30 se déplace par rapport à la portée d'appui 42 du lobe de débattement 39, se rapprochant de celle-ci.

Le bord longitudinal 18 supérieur du volet 14, c'est-à-dire celui de ses bords longitudinaux 17, 18 le long duquel se fait son pivotement, peut ainsi suivre le retour 24 rectiligne correspondant de la fenêtre 12 de la paroi de façade 11, sans interférer avec ce retour 24.

Lors d'une étape suivante de l'ouverture du volet, figure 10C, après que le méplat 32 des tourillons soit venu s'appliquer contre la portée d'appui 42 du lobe de 39 de débattement, l'arête arrière des méplats 32 glisse à son tour sur la portée d'appui 42 du lobe de débattement 39 et la partie cylindrique des tourillons proche de cette arête arrière glisse simultanément sur le troisième côté 43 du lobe de débattement 39 jusqu'à ouverture complète du volet. Pendant cette étape de l'ouverture du volet, l'axe des tourillons 30 se déplace par rapport à la portée d'appui 42, s'éloignant de celle-ci.

La fermeture du volet 14 comprend, comme l'ouverture du volet 14, les deux mêmes étapes, mais dans l'ordre inverse.

Lors du débattement du volet, tant lors de sa fermeture que lors de son ouverture, les tourillons 30 sont donc guidés dans le lobe de débattement 39 et le profil de came des tourillons détermine les déplacements de l'axe réel de rotation des tourillons avec la position angulaire du volet. Ainsi, se trouve réalisée une action de guidage déterminant pour le volet une trajectoire dégagée par rapport au retour rectiligne 24 de la fenêtre 12 : en maintenant une certaine distance entre les bords du volet et le retour correspondant de la fenêtre on évite ainsi tout risque de blocage du volet, l'utilisateur n'ayant aucun effort à fournir pour guider le volet lors de son débattement.

Enfin, lorsque, au terme de son pivotement, le volet 14 arrive en position d'ouverture, figure 10C, ses bras de maintien 35 viennent se prendre par leur bossage 36 sur l'épaulement 37 correspondant des retours 23 de la fenêtre 12 de la paroi de façade 11, tel que schématisé en traits interrompus sur la figure 11, ce qui assure un maintien stable de ce volet 14 dans cette position d'ouverture.

Pour cette position d'ouverture, le volet 14 trouve avantageusement un appui élargi sur les épaulements 49 de largeur accrue des retours 23 de la fenêtre 12.

Préférentiellement, et cela est le cas dans la forme de réalisation représentée, l'épaisseur du bossage 47 des retours 23 de la fenêtre 12 de la paroi de façade 11 va en décroissant de l'épaulement 37 qui le limite au dégagement 26 correspondant, et, plus précisément, au lobe de montage 45 de ce dégagement 26, figure 4.

Ainsi, les bras de maintien 35 du volet 14 ne sont avantageusement pas sous contrainte lorsque ce volet 14 est en position de fermeture, ce qui est le cas le plus fréquent, et leur élasticité se trouve ainsi avantageusement ménagée.

Bien entendu, la présente invention ne se limite pas à la forme de réalisation décrite et représentée, mais englobe toute variante d'exécution, selon les revendications.

En particulier, les rôles respectifs des bords transversaux et longitudinaux peuvent être intervertis, tant pour la fenêtre de la paroi de façade que pour le volet, et il en est de même pour les rôles respectifs de leurs bords supérieur et inférieur.

## Revendications

1. Capot du genre comportant une paroi de façade (11), dans laquelle est ménagée une fenêtre (12), et un volet (14), qui est monté pivotant entre une position de fermeture, pour laquelle il occulte cette fenêtre (12), et une position d'ouverture, pour laquelle il libère celle-ci, la fenêtre (12) de la paroi de façade (11) comportant, le long de chacun de deux bords transversaux (20), sur une partie au moins de la longueur de ces bords transversaux (20), un retour (23), qui est dirigé vers l'intérieur, et dans lequel est ménagé en creux un dégagement (26), et le volet (14) comportant, en correspondance, en saillie sur chacun de ses deux bords transversaux (21), un tourillon (30), qui s'étend parallèlement à sa surface avant (22), à proximité d'un de ses bords longitudinaux (18, 19), et par lequel il est en prise à pivotement avec le dégagement (26) du retour (23) correspondant de la fenêtre (12) de la paroi de façade (11), **caractérisé en ce que** les deux tourillons (30) que comporte ainsi le volet (14) sont chacun tronqués par un méplat (32) en correspondance l'un avec l'autre.

2. Capot suivant la revendication 1, **caractérisé en ce que** les tourillons (30) du volet (14) s'étendent en retrait par rapport au bord longitudinal (18) correspondant de celui-ci.

3. Capot suivant l'une quelconque des revendication 1, 2, **caractérisé en ce que** le méplat (32) des tourillons (30) du volet (14) fait un dièdre (D) d'angle aigu avec la surface avant (22) de ce volet 14 et est tourné vers le bord longitudinal (19) opposé de celui-ci.

4. Capot suivant la revendication 3, **caractérisé en ce que** l'angle du dièdre (D) que fait le méplat (32) des tourillons (30) du volet (14) avec la surface avant (22) de celui-ci est compris entre 30° et 60°.

5. Capot suivant la revendication 4, **caractérisé en ce que** l'angle du dièdre (D) que fait le méplat (32) des tourillons (30) du volet (14) avec la surface avant (22) de celui-ci est de l'ordre de 45°.

6. Capot suivant l'une quelconque des revendications 1 à 5, **caractérisé en ce que** les tourillons (30) du volet (14) sont déportés vers l'intérieur par rapport à la surface avant (22) de celui-ci.

7. Capot suivant la revendication 6, **caractérisé en ce que** chacun des tourillons (30) du volet (14) fait saillie sur la surface arrière (33) de celui-ci, en se raccordant à cette surface arrière (33) par une nervure (34) formant globalement pour lui un berceau.

8. Capot suivant l'une quelconque des revendications 1 à 7, **caractérisé en ce que** le dégagement (26) que présente chacun des retours (23) de la fenêtre (12) de la paroi de façade (11) comporte un lobe (39) propre à un débattement du tourillon (30) correspondant du volet (14), le contour de ce lobe (39), dit lobe de débattement, comportant, notamment, un côté curviligne (40), en arc de cercle, dont la concavité est tournée vers l'intérieur et vers le bord longitudinal (17) opposé de la fenêtre (12), et qui s'étend sur environ 90°, suivant un rayon (R) sensiblement égal au rayon (R) du tourillon (30), un premier côté droit (41), qui, dirigé vers ce bord longitudinal (17) de la fenêtre (12), est tangent au côté curviligne (40), et dont la longueur (L) est au moins égale au rayon (R) du tourillon (30), et un deuxième côté droit (42), qui, dirigé vers l'intérieur, fait un angle sensiblement droit avec le premier côté droit (41).

9. Capot suivant la revendication 8, **caractérisé en ce que** le lobe de débattement (39) du dégagement (26) des retours (23) de la fenêtre (12) de la paroi de façade (11) comporte un troisième côté droit (43), qui, dirigé vers le bord longitudinal (16) concerné de la fenêtre (12), s'étend sensiblement parallèlement au premier côté droit (41), et ce dégagement (26) comporte, à compter de ce troisième côté droit (43) et du côté curviligne (40), un deuxième lobe (45), qui s'étend globalement vers l'intérieur.

10. Capot selon la revendication 9, **caractérisé en ce qu'**en position de fermeture, les tourillons (30) du volet (14) sont au contact du coté curviligne (40) des lobes de débattement (39).

11. Capot selon la revendication 10, **caractérisé en ce que** lors du débattement du volet (14), le méplat (32) des tourillons (30) entre en contact avec le deuxième côté droit (42) du lobe de débattement (39) formant portée d'appui (figure 10B).

12. Capot selon la revendication 11, **caractérisé en ce que** alors qu'une arête du méplat (32) des tourillons (30) est en contact avec la portée d'appui (42) du lobe de débattement (39) et glisse sur celle-ci (figure 10A), une deuxième arête du méplat (32) ou une génératrice des tourillons (30) à proximité de la dite deuxième arête du méplat (32) glisse sur le troisième côté droit (43) du lobe (39) de débattement.

13. Capot selon la revendication 12, **caractérisé en ce que** dans une étape (figure 10C) du débattement du volet (14) où la deuxième arête du méplat (32) des tourillons (30) est en contact avec la portée d'appui (42) du lobe de débattement (39) et glisse sur celle-ci, une génératrice des tourillons (30) à proximité de la dite deuxième arête du méplat (32) glisse sur le troisième côté droit (43) du lobe (39) de débattement.

14. Capot suivant l'une quelconque des revendications 1 à 13, **caractérisé en ce que** le long de celui au moins de ses bords longitudinaux (16, 17) à proximité duquel se fait le pivotement du volet (14), la fenêtre (12) de la paroi de façade (11) comporte également un retour (24), qui est dirigé vers l'intérieur, et dont la section transversale est une droite.

15. Capot suivant les revendications 8 et 14, prises conjointement, **caractérisé en ce que** le deuxième côté droit (42) du lobe de débattement (39) du dégagement (26) des retours (23) de la fenêtre (12) de la paroi de façade (11) est sensiblement parallèle à la section transversale du retour (24) que cette fenêtre (12) présente le long de celui de ses bords longitudinaux (16, 17) à proximité duquel se fait le pivotement du volet (14).

16. Capot suivant l'une quelconque des revendications 1 à 15, **caractérisé en ce que** le volet (14) comporte, également, en saillie sur sa surface arrière (33), le long de chacun de ses bords transversaux (21), un bras de maintien (35), qui s'étend sensiblement perpendiculairement à sa surface avant (22), et qui est élastiquement déformable, avec, en saillie vers l'extérieur sur ce bras de maintien (35), un bossage (36) propre à son encliquetage sur un épaulement (37) prévu à cet effet sur le retour (23) correspondant de la fenêtre (12) de la paroi de façade (11).

17. Capot suivant l'une quelconque des revendications 1 à 16, **caractérisé en ce que** la surface avant (15) de la paroi de façade (11) est bombée, suivant une forme générale cylindrique, et le volet (14) est monté pivotant autour d'un axe parallèle aux génératrices de cette surface avant (15).

18. Capot suivant l'une quelconque des revendications 1 à 17, **caractérisé en ce que** les bords longitudinaux supérieur (16) et inférieur (17) de la fenêtre (12) de la paroi de façade (11) sont cintrés, avec leurs concavités tournées l'une vers l'autre, et les bords longitudinaux supérieur (18) et inférieur (19) du volet (14) sont eux-mêmes cintrés, avec leurs concavités tournées l'une vers l'autre.

19. Capot suivant l'une quelconque des revendications 1 à 18, **caractérisé en ce que**, en position de fermeture, le volet (14) s'encastre dans la fenêtre (12) de la paroi de façade (11).

20. Capot suivant les revendications 17 et 19, prises conjointement, **caractérisé en ce que** le volet (14) est bombé, et, lorsqu'il est en position de fermeture, sa surface avant (22) vient en continuité avec la surface avant (15) de la paroi de façade (11).

21. Organe d'obturation (14) d'une fenêtre (12), monté pivotant entre une position de fermeture pour laquelle il occulte cette fenêtre (12), et une position d'ouverture pour laquelle il libère celle-ci, la fenêtre (12) de la paroi de façade (11) comportant, le long de partie au moins de ses côtés, un retour (23, 24) dirigé vers l'intérieur, l'organe d'obturation (14) comportant, en saillie sur chacun de ses bords transversaux (21), un tourillon (30) de pivotement dans un dégagement (26) du retour (23, 24) correspondant de la fenêtre (12), **caractérisé en ce que**, les deux tourillons (30) présentent un profil de came déterminant une loi de variation de la distance entre l'axe réel de rotation de l'organe d'obturation (14) et une portée (42) d'appui des tourillons dans le dégagement (26) en fonction de l'angle d'ouverture de l'organe d'obturation (14) par rapport à la paroi de façade (11).

## Claims

1. A cover of the type comprising a façade wall (11) provided with a window (12) and a flap (14) which is pivotally mounted between a closed position where it obscures said window (12) and an open position which frees it, the window (12) of the façade wall (11), along each of two transverse edges (20) over at least part of the length of said transverse edges (20), comprising a return (23) which is directed inwardly, and into which a recessed relief (26) is formed, and the flap (14) comprising a pin (30), in register with the relief, projecting over each of the transverse edges (21) and extending parallel to its front surface (22) close to one of its longitudinal edges (18, 19) and via which it is pivotally engaged with the recessed relief (26) of the corresponding return (23) of the window (12) of the wall of the façade (11), **characterized in that** the two pins (30) carried by the flap (14) are each truncated by a flattened part (32) which correspond with each other.

2. A cover according to claim 1, **characterized in that** the pins (30) of the flap (14) are set back with respect to the corresponding longitudinal edge (18) thereof.

3. A cover according to claim 1 or claim 2, **characterized in that** the flattened part (32) of the pins (30) of the flap (14) makes a dihedral angle (D) with an acute angle with the front surface (22) of said flap (14) and is turned towards the opposite longitudinal edge (19) thereof.

4. A cover according to claim 3, **characterized in that** the dihedral angle (D) which the flattened part (32) of the pins (30) of the flap (14) makes with the front surface (22) thereof is in the range 30° to 60°.

5. A cover according to claim 4, **characterized in that** the dihedral angle (D) which the flattened part (32) of the pins (30) of the flap (14) makes with the front surface (22) thereof is of the order of 45°.

6. A cover according to any one of claims 1 to 5, **characterized in that** the pins (30) of the flap (14) are displaced inwardly with respect to the front surface (22) thereof.

7. A cover according to claim 6, **characterized in that** each of the pins (30) of the flap (14) projects over the back surface (33) thereof, connecting at said back surface (33) via a rib (34) generally forming a mount therefore.

8. A cover according to any one of claims 1 to 7, **characterized in that** the recessed relief (26) of each of the returns (23) of the window (12) of the façade wall (11) comprises a lobe (39) matching the travel of the corresponding pin (30) of the flap (14), the contour of said lobe (39), termed the travel lobe, comprising, notably, a curvilinear side (40) formed as a circular arc, the concavity of which is turned inwardly and towards the opposite longitudinal edge (17) of the window (12), and which extends over about 90° with a radius (R) substantially equal to the radius (R) of the pin (30), a first straight side (41) which is directed towards said longitudinal edge (17) of the window (12) and is tangential to the curvilinear side (40) and has a length (L) which is at least equal to the radius (R) of the pin (30), and a second straight side (42) which is directed inwardly and is substantially at right angles to the first straight side (41).

9. A cover according to claim 8, **characterized in that** the travel lobe (39) of the recessed relief (26) of the returns (23) of the window (12) of the façade wall (11) comprises a third straight side (43) which is directed towards the longitudinal edge (16) concerned of the window (12) and extends substantially parallel to the first straight side (41), and said recessed relief (26) comprises a second lobe (45) which extends generally inwardly, starting from said third straight side (43) and the curvilinear side (40).

10. A cover according to claim 9, **characterized in that** in the closed position, the pins (30) of the flap (14) are in contact with the curvilinear side (40) of the travel lobes (39).

11. A cover according to claim 10, **characterized in that** during travel of the flap (14), the flattened part (32) of the pins (30) comes into contact with the second straight side (42) of the travel lobe (39) forming a bearing surface (Figure 10B).

12. A cover according to claim 11, **characterized in that** a further edge of the flattened part (32) of the pins (30) is in contact with the bearing surface (42) of the travel lobe (39) and slides thereon (Figure 10A), a second edge of the flattened part (32) or a generatrix of the pins (30) close to said second edge of the flattened part (32) slides on the third straight side (43) of the travel lobe (39).

13. A cover according to claim 12, **characterized in that** in one step (Figure 10C) of the travel of the flap (14) where the second edge of the flattened part (32) of the pins (30) is in contact with the bearing surface (42) of the travel lobe (39) and slides thereon, a generatrix of the pins (30) close to said second edge of the flattened part (32) slides on the third straight side (43) of the travel lobe (39).

14. A cover according to any one of claims 1 to 13, **characterized in that** along at least that of its longitudinal edges (16, 17) close to which the flap (14) pivots, the window (12) of the façade wall (11) also comprises a return (24) which is directed inwardly, the transverse cross section of which is a straight line.

15. A cover according to claims 8 and 14, in combination, **characterized in that** the second straight side (42) of the travel lobe (39) of the recessed relief (26) of the returns (23) of the window (12) of the façade wall (11) is substantially parallel to the transverse section of the return (24) which said window (12) has along that of its longitudinal edges (16, 17) close to which the flap (14) pivots.

16. A cover according to any one of claims 1 to 15, **characterized in that** the flap (14) also comprises, projecting from its back surface (33), along each of its transverse edges (21), a holding arm (35) which extends substantially perpendicular to its front surface (22) and which is elastically deformable with, projecting outwardly on said holding arm (35), a boss (36) which can be snap fitted onto a shoulder (37) provided for this purpose on the corresponding return (23) of the window (12) of the facade wall (11).

17. A cover according to any one of claims 1 to 16, **characterized in that** the front surface (15) of the façade wall (11) is bulged into a generally cylindrical shape and the flap (14) is pivotally mounted about an axis parallel to the generatrices of said front surface (15).

18. A cover according to any one of claims 1 to 17, **characterized in that** the upper (16) and lower (170 longitudinal edges of the window (12) of the façade wall (11) are curved, with their concavities turned towards each other, and the upper (18) and lower (19) longitudinal edges of the flap (14) are also curved, with their concavities turned towards each other.

19. A cover according to any one of claims 1 to 18, **characterized in that** in the closed position, the flap (14) is imbedded in the window (12) of the façade wall (11).

20. A cover according to claims 17 and 19, in combination, **characterized in that** the flap (14) is bulged and, when in the closed position, its front surface (22) is continuous with the front surface (15) of the façade wall (11).

21. A member (14) for obturating a window (12), pivotally mounted between a closed position in which it obturates said window (12) and an open position where it is open, the window (12) of the façade wall (11) comprising, along at least a part of its sides, an inwardly directed return (23, 24), the obturating member (14) comprising, projecting over each of its transverse edges (21), a pin (30) for pivoting in a recessed relief (26) of the corresponding return (23, 24) of the window (12), **characterized in that** the two pins (30) have a cam profile determining a law of variation of the distance between the actual rotational axis of the obturating member (14) and a bearing surface (42) for the pins in the recessed relief (26) as a function of the angle of opening of the obturating member (14) with respect to the façade wall (11).

## Patentansprüche

1. Scharnierdeckel des Typs mit einer Stirnwand (11), in der ein Fenster (12) ausgebildet ist, und einer Klappe (14), die schwenkbar zwischen einer geschlossenen Position, in der sie dieses Fenster (12) verdeckt, und einer geöffneten Position, in der sie dieses freigibt, gelagert ist, wobei das Fenster (12) der Stirnwand (11) entlang jeder von zwei Querrändern (20) auf wenigstens einem Tell der Länge dieser Querränder (20) einen nach innen gerichteten Rücksprung (23) aufweist, in dem vertieft eine Aussparung (26) ausgebildet ist, und wobei die Klappe (14) entsprechend auf jeden ihrer beiden Querränder (21) einen überstehenden Zapfen (30) umfasst, der sich parallel zu ihrer Vorderseite (22) in der Nähe einer ihrer Längsränder (18, 19) erstreckt und durch den sie in die Aussparung (26) des entsprechenden Rücksprungs (23) des Fensters (12) der Stirnwand (11) schwenkbar eingreift,
**dadurch gekennzeichnet, dass** die beiden Zapfen (30), welche die Klappe (14) somit aufweist, jeweils durch eine Abflachung (32) abgestumpft sind, von denen die eine mit der anderen übereinstimmt.

2. Scharnierdeckel nach Anspruch 1,
**dadurch gekennzeichnet, dass** sich die Zapfen (30) der Klappe (14) bezüglich des entsprechenden Längsrandes (18) derselben zurückversetzt erstrecken.

3. Scharnierdeckel nach einem der Ansprüche 1, 2,
**dadurch gekennzeichnet, dass** die Abflachung (32) der Zapfen (30) der Klappe (14) mit der Vorderseite (22) dieser Klappe (14) einen Dieder (D) mit spitzem Winkel bildet und dem ihr entgegengesetzten Längsrand (19) zugewandt ist.

4. Scharnierdeckel nach Anspruch 3,
**dadurch gekennzeichnet, dass** der Winkel des Dieders (D), den die Abflachung (32) der Zapfen (30) der Klappe (14) mit deren Vorderseite (22) bildet, 30° bis 60° beträgt.

5. Scharnierdeckel nach Anspruch 4,
**dadurch gekennzeichnet, dass** der Winkel des Dleders (D), den die Abflachung (32) der Zapfen (30) der Klappe (14) mit deren Vorderseite (22) bildet, etwa 45° beträgt.

6. Scharnierdeckel nach einem der Ansprüche 1 bis 5,
**dadurch gekennzeichnet, dass** die Zapfen (30) bezüglich der Vorderseite (22) der Klappe (14) nach innen versetzt sind.

7. Scharnierdeckel nach Anspruch 6,
**dadurch gekennzeichnet, dass** jeder der Zapfen (30) über die Rückseite (33) der Klappe (14) übersteht und dabei durch eine Rippe (34), die allgemein eine Halterung für ihn bildet, mit dieser Rückseite (33) verbunden ist.

8. Scharnierdeckel nach einem der Ansprüche 1 bis 7,
**dadurch gekennzeichnet, dass** die Aussparung (26), die jeder der Rücksprünge (23) des Fensters (12) der Stirnwand (11) umfasst, einen Bogen (39) aufweist, der für einen Ausschlag des entsprechenden Zapfens (30) der Klappe (14) geeignet ist, wobei der Umriss des als Ausschlagbogen bezeichneten Bogens (39) insbesondere eine gekrümmte, kreisbogenförmige Seite (40) umfasst, deren konkave Krümmung nach innen und dem entgegengesetzten Längsrand (17) des Fensters (12) zugewandt ist und sich über ungefähr 90° gemäß einem Radius (R) erstreckt, der im Wesentlichen dem Radius (R) des Zapfens (30) entspricht, sowie eine erste gerade Seite (41), die diesem Längsrand (17) des Fensters (12) zugewandt die gekrümmte Seite (40) tangiert und deren Länge (L) mindestens dem Radius (R) des Zapfens (30) entspricht, und eine zweite gerade Seite (42), die nach innen gewandt mit der ersten geraden Seite (41) einen im Wesentlichen rechten Winkel bildet.

9. Scharnierdeckel nach Anspruch 8,
**dadurch gekennzeichnet, dass** der Ausschlagbogen (39) der Aussparung (26) der Rücksprünge (23) des Fensters (12) der Stirnwand (11) eine dritte gerade Seite (43) umfasst, die sich dem betreffenden Längsrand (16) des Fensters (12) zugewandt im Wesentlichen parallel zu der ersten geraden Seite (41) erstreckt, und die Aussparung (26) ab dieser dritten geraden Seite (43) und der gekrümmten Seite (40) einen zweiten Bogen (45) aufweist, der allgemein nach innen verläuft.

10. Scharnierdeckel nach Anspruch 9,
**dadurch gekennzeichnet, dass** die Zapfen (30) der Klappe (14) in der geschlossenen Position mit der gekrümmten Seite (40) der Ausschlagbogen (39) in Berührung sind.

11. Scharnierdeckel nach Anspruch 10,
**dadurch gekennzeichnet, dass** die Abflachung (32) der Zapfen (30) während des Ausschlags der Klappe (14) mit der zweiten geraden Seite (42) des Ausschlagbogens (39) in Berührung kommt, die eine Auflagefläche bildet (Figur 10B).

12. Scharnierdeckel nach Anspruch 11,
**dadurch gekennzeichnet, dass** eine zweite Kante der Abflachung (32) oder eine Mantellinie der Zapfen (30) in der Nähe dieser zweiten Kante der Abflachung (32) auf der dritten geraden Seite (43) des Ausschlagbogens (39) gleitet, während eine Kante der Abflachung (32) der Zapfen (30) mit der Auflagefläche (42) des Ausschlagbogens (39) in Berührung ist und auf dieser gleitet (Figur 10A).

13. Scharnierdeckel nach Anspruch 12,
**dadurch gekennzeichnet, dass** bei einer Etappe (Figur 10C) des Ausschlags der Klappe (14), während der die zweite Kante der Abflachung (32) der Zapfen (30) mit der Auflagefläche (42) des Ausschlagbogens (39) in Berührung ist und auf dieser gleitet, eine Mantellinie der Zapfen (30) in der Nähe der zweiten Kante der Abflachung (32) auf der dritten geraden Seite (43) des Ausschlagbogens (39) gleitet.

14. Scharnierdeckel nach einem der Ansprüche 1 bis 13,
**dadurch gekennzeichnet, dass** das Fenster (12) der Stirnwand (11) wenigstens entlang desjenigen seiner Längsränder (16,17), in dessen Nähe das Schwenken der Klappe (14) erfolgt, ebenfalls einen Rücksprung (24) aufweist, der nach innen gerichtet ist und dessen Querschnitt eine Gerade ist.

15. Scharnierdeckel nach Anspruch 8 und 14 in Verbindung miteinander,
**dadurch gekennzeichnet, dass** die zweite gerade Seite (42) des Ausschlagbogens (39) der Aussparung (26) der Rücksprünge (23) des Fensters (12) der Stirnwand (11) im Wesentlichen parallel zu dem Querschnitt des Rücksprungs (24) ist, den dieses Fenster (12) entlang desjenigen seiner Längsränder (16, 17) aufweist, in dessen Nähe das Schwenken der Klappe (14) erfolgt.

16. Scharnierdeckel nach einem der Ansprüche 1 bis 15,
**dadurch gekennzeichnet, dass** die Klappe (14) ferner entlang jedem ihrer Querränder (21) einen über ihre Rückseite (33) überstehenden Haltearm (35) aufweist, der sich im Wesentlichen senkrecht zu ihrer Vorderseite (22) erstreckt und elastisch verformbar ist, mit einem an dem Haltearm (35) nach außen überstehenden Vorsprung (36), der zum Einrasten auf einem Absatz (37) geeignet ist, der hierzu an dem entsprechenden Rücksprung (23) des Fensters (12) der Stirnwand (11) vorgesehen ist.

17. Scharnierdeckel nach einem der Ansprüche 1 bis 16,
**dadurch gekennzeichnet, dass** die Vorderseite (15) der Stirnwand (11) gemäß einer allgemein zylindrischen Form gewölbt ist und die Klappe (14) um eine zu den Mantellinien dieser Vorderseite (15) parallele Achse schwenkbar gelagert ist.

18. Scharnierdeckel nach einem der Ansprüche 1 bis 17,
**dadurch gekennzeichnet, dass** der obere (16) und der untere (17) Längsrand des Fensters (12) der Stirnwand (11) gebogen sind, wobei ihre konkaven Krümmungen einander zugewandt sind, und dass der obere (18) und der untere (19) Längsrand der Klappe (14) ihrerseits gebogen sind, wobei ihre konkaven Krümmungen einander zugewandt sind.

19. Scharnierdeckel nach einem der Ansprüche 1 bis 18,
**dadurch gekennzeichnet, dass** sich die Klappe (14) in der geschlossenen Position in das Fenster (12) der Stirnwand (11) einfügt.

20. Scharnierdeckel nach Anspruch 17 und 19 in Verbindung miteinander,
**dadurch gekennzeichnet, dass** die Klappe (14) gewölbt ist und ihre Vorderseite (22) in Fortsetzung der Vorderseite (15) der Stirnwand verläuft, wenn sie sich in der geschlossenen Position befindet.

21. Organ (14) zum Verschließen eines Fensters (12), das zwischen einer geschlossenen Position, in der es dieses Fenster (12) verdeckt, und einer geöffneten Position, in der es dieses freigibt, schwenkbar gelagert ist, wobei das Fenster (12) der Stirnwand (11) wenigstens entlang eines Teils seiner Seiten einen nach innen gerichteten Rücksprung (23, 24) aufweist, wobei das Verschlussorgan (14) an jedem seiner Querränder (21) einen überstehenden Drehzapfen (30) in einer Aussparung (26) des entsprechenden Rücksprungs (23, 24) des Fensters (12) umfasst,
**dadurch gekennzeichnet, dass** die beiden Zapfen (30) ein Nockenprofil aufweisen, das ein Gesetz über die Veränderung des Abstands zwischen der tatsächlichen Drehachse des Verschlussorgans (14) und einer Auflagefläche (42) der Zapfen in der Aussparung (26) in Abhängigkeit vom Öffnungswinkel des Verschlussorgans (14) bezüglich der Stirnwand (11) festlegt.
